# EUROPÄISCHE PATENTSCHRIFT

(11) **EP 1 441 580 B1**
(45) Veröffentlichungstag und Bekanntmachung des Hinweises auf die Patenterteilung: **30.09.2009**
(21) Anmeldenummer: 04001168.6
(22) Anmeldetag: 21.01.2004
(51) Int. Cl.: H05K 7/14

(54) **Schaltungsmodul**
Circuit module
Module avec circuit

(30) Priorität: 23.01.2003 DE 10302485
(43) Veröffentlichungstag der Anmeldung: 28.07.2004
(73) Patentinhaber: ABB PATENT GmbH, 68526 Ladenburg (DE)
(72) Erfinder: Zank, Gunnar, Dipl.-Ing., 06179 Teutschenthal (DE); Schollenberger, Lothar, Dipl.-Ing., 69493 Hirschberg (DE); Garrels, Kai, Dipl.-Ing. (BA), 68239 Mannheim (DE)
(74) Vertreter: Miller, Toivo

(56) Entgegenhaltungen:
- WO-A-93/15464
- US-A- 5 408 616
- US-A- 5 617 081

## Beschreibung

Die Erfindung betrifft ein Schaltungsmodul zur Anschaltung von Schaltgeräten an einen Feldbus. Die Erfindung betrifft auch eine Schaltungsanordnung und eine Schaltanlage, insbesondere in Einschubtechnik, mit einem erfindungsgemäßen Schaltungsmodul.

Allgemein bekannt sind Schaltanlagen, insbesondere Niederspannungsschaltanlagen, in denen elektrische oder elektronische Schaltgeräte zum Steuern und Überwachen eines oder mehrerer Verbraucher, beispielsweise eines Motors, enthalten sind. Die Schaltgeräte sind zusammen mit anderen Komponenten, wie beispielsweise Hauptschalter und Schütze, in ausfahrbare Einschübe eingebaut, wobei in jedem Einschub in der Regel ein Schaltgerät vorhanden ist. Die Einschübe sind mit dem feststehenden Teil der Schaltanlage mittels Steckverbindern, sogenannten Steuersteckern, verbunden, die so angeordnet sind, dass beim Einfahren des Einschubs in ein Einschubfach die Kontaktierung der Steuerstecker automatisch stattfindet.

Die Schaltgeräte einer Schaltanlage sind über die Steuerstecker der Einschübe an einen gemeinsamen Feldbus angeschlossen, über den ein Datenaustausch mit einem Leitsystem ermöglicht ist. So kann jedes Schaltgerät Befehle und Abfragen vom Leitsystem empfangen und Meldungen zum Leitsystem übertragen.

Das Schaltgerät verfügt über eine interne Feldbusanschaltung, das heißt, über eine Kommunikationsschnittstelle, die den Datenaustausch des Schaltgeräts mit dem Feldbus steuert. Die Feldbusadresse, mit der das Schaltgerät vom Leitsystem über den Feldbus angesprochen wird, ist im Schaltgerät selbst hinterlegt, beispielsweise in einem internen Speicher, oder sie ist mittels eines Kodierschalters einstellbar.

Beim Auswechseln eines Schaltgeräts oder eines kompletten Einschubs, beispielsweise zu Wartungszwecken, müssen die Konfigurationsparameter des neuen Schaltgeräts identisch zu denen des ausgewechselten Schaltgeräts eingestellt werden. Insbesondere muss die Feldbusadresse korrekt eingestellt werden, damit das Leitsystem über die Feldbusadresse mit dem neuen Schaltgerät kommunizieren kann.

Sind die Parameter nur im Schaltgerät selbst gespeichert, so ist eine meist zeitaufwendige und fehleranfällige Parametrierung nötig.

Bei Feldbussen besteht das Problem, dass beim Ausfahren eines Einschubs aus einem Einschubfach die Kommunikation des eingebauten Schaltgerätes mit dem Feldbus und mit dem Leitsystem unterbrochen wird. Solch eine Unterbrechung kann, ebenso wie die Wiederaufnahme der Kommunikation nach Einfahren des Einschubs, Störungen auf dem Feldbus hervorrufen. Insbesondere kann ein Datenverlust auftreten, wenn ein Schaltgerät während des Sendens eines Datentelegramms entfernt wird, und es kann zu Telegrammkollisionen kommen, wenn ein Schaltgerät an den Feldbus angeschlossen wird und seine Initialisierungsphase startet, während ein anderes Schaltgerät Daten sendet.

Bei bestimmten Verkabelungsarten, beispielsweise bei einer RS485-Verdrahtung, ist auch die Verkabelung problematisch. Idealerweise ist solch ein Bussystem als Ringleitung ausgeführt und alle Schaltgeräte sind direkt an die Ringleitung angeschlossen. Bei Schaltanlagen in Einschubtechnik ist eine reine Ringleitung nicht praktikabel, da bei Ausfahren eines Einschubs die Leitung unterbrochen würde. Eine Möglichkeit zur Verkabelung ist die Verlegung einer Ringleitung oder Stammleitung im feststehenden Teil der Schaltanlage bis zu den Einschubfächern und von dort die Verlegung von Stichleitungen zu den Steuersteckern der Einschübe und weiter bis zu den Schaltgeräten in den Einschüben.

Stichleitungen können jedoch Reflexionen und andere Störungen auf dem Feldbus hervorrufen und beschränken daher die Übertragungsbandbreite- und geschwindigkeit.

Aufgabe der Erfindung ist es, eine Einrichtung zu schaffen, die eine vereinfachte Anschaltung von Schaltgeräten an einen Feldbus ermöglicht.

Die Aufgabe wird erfindungsgemäß durch ein Schaltungsmodul mit den im Anspruch 1 genannten Merkmalen gelöst.

Erfindungsgemäß wird ein Schaltungsmodul vorgesehen, welches eine Feldbusschnittstelle zum Anschluss an einen Feldbus und eine oder mehrere Kommunikationsschnittstellen zum Anschluss eines oder mehrerer Schaltgeräte aufweist. Im Betriebsfall ist dabei eine Kommunikation des Schaltungsmoduls über den Feldbus auch dann vorgesehen, wenn kein Schaltgerät an eine der Kommunikationsschnittstellen angeschlossen ist.

Durch An- oder Abschalten eines Schaltgerätes bleibt die Feldbusschnittstelle somit unbeeinflusst, und Störungen auf dem Feldbus sind vermieden.

Im jedem Schaltungsmodul ist eine Feldbusadresse einstellbar, die zur Kommunikation mit einem Leitsystem benötigt wird. Das Schaltgerät ist über eine Punkt-zu-Punkt-Verbindung mit dem Schaltungsmodul verbunden und benötigt daher keine Busadresse. Somit entfällt die manuelle und fehleranfällige Adresseinstellung im Schaltgerät. Beim Auswechseln eines Schaltgerätes bleibt die Feldbusadresse erhalten.

Die Feldbusadresse des Schaltungsmoduls kann beispielsweise mit Hilfe eines Programmiergeräts eingestellt, geändert und gespeichert werden. Dieses Programmiergerät kann über eine Kommunikationsschnittstelle oder über die Feldbusschnittstelle mit dem Schaltungsmodul verbunden werden.

In einer vorteilhaften Ausgestaltung weist das Schaltungsmodul ein Dekodiermittel zur Einstellung der Feldbusadresse auf. Die Feldbusadresse ist dabei in einem Kodiermittel enthalten, welches von dem Dekodiermittel interpretierbar ist. Beispielsweise ist das Dekodiermittel als Stecker ausgeführt und das Kodiermittel als entsprechender Gegenstecker. Die Einstellung der Feldbusadresse erfolgt dann durch Anbringen des Gegensteckers, in welchem die Feldbusadresse hinterlegt ist. In einer alternativen Ausführungsform ist das Dekodiermittel als Barcode-Leser ausgeführt und das Kodiermittel als Barcode-Etikett. Auf diese Art wird die Einstellung der Feldbusadresse vereinfacht.

Die Feldbusschnittstelle kann einen oder mehrere Anschlüsse aufweisen, die als ein- oder mehrpolige Steck- oder Schraubverbindungen ausgelegt sein können. Wenn der Feldbus als Ringleitung zu realisieren ist, so verfügt die Feldbusschnittstelle über zwei Anschlüsse, mit deren Hilfe das Schaltungsmodul in den Ring eingeschleift wird. Es erweist sich als vorteilhaft, den ersten der beiden Anschlüsse als Steckverbinder auszulegen und am zweiten Anschluss ein Verbindungskabel mit dem entsprechenden Gegenstecker anzubringen, um damit die Verbindung zum benachbarten Schaltungsmodul herzustellen.

Die Feldbusschnittstelle und die wenigstens eine Kommunikationsschnittstelle des Schaltungsmoduls sind für einen bidirektionalen Datenaustausch eingerichtet.

So kann das Schaltungsmodul Daten, wie beispielsweise Befehle, Abfragen oder Meldungen, über die Feldbusschnittstelle empfangen und, falls diese für ein angeschlossenes Schaltgerät bestimmt sind, über die entsprechende Kommunikationsschnittstelle an dieses weiterleiten. Die empfangenen Daten können dabei von einem Leitsystem, von anderen Schaltungsmodulen und/oder von sonstigen Busteilnehmern stammen. Weiterhin kann das Schaltungsmodul Daten, die es über eine Kommunikationsschnittstelle von einem Schaltgerät empfängt, über die Feldbusschnittstelle zum Feldbus und insbesondere zu einem Leitsystem, zu anderen Schaltungsmodulen und/oder zu sonstigen Busteilnehmern übertragen.

Gemäß einer vorteilhaften Ausgestaltung der Erfindung besitzt ein Schaltungsmodul mehrere Kommunikationsschnittstellen, an die jeweils ein Schaltgerät angeschlossen werden kann. Das Schaltungsmodul besitzt in diesem Fall auch ebenso viele Feldbusadressen, wobei jeder Kommunikationsschnittstelle eine separate Feldbusadresse zugeordnet ist. Die Feldbusadressen werden sinnvollerweise fortlaufend vergeben. Hat beispielsweise ein Schaltungsmodul 4 Kommunikationsschnittstellen und wird am Schaltungsmodul die Adresse "40" eingestellt, so werden den Kommunikationsschnittstellen automatisch die Adressen "40", "41", "42" und "43" zugeordnet.

Das Schaltungsmodul überwacht ständig die angeschlossenen Schaltgeräte. Wird die Verbindung zu einem Schaltgerät gestört oder unterbrochen, so detektiert das Schaltungsmodul die Störung und/oder Unterbrechung. Gegebenenfalls sendet das Schaltungsmodul eine entsprechende Diagnosemeldung an das Leitsystem, beispielsweise "Adresse 41 - Gerät entfernt".

Empfängt das Schaltungsmodul Befehle oder Abfragen für ein Schaltgerät, zu dem die Verbindung unterbrochen ist, so beantwortet es das Befehls- oder Abfragetelegramm, beispielsweise mit der Meldung "Adresse 41 - Gerät nicht verfügbar", anstatt das Telegramm an die Kommunikationsschnittstelle weiterzuleiten.

In einer weiteren vorteilhaften Ausgestaltung der Erfindung werden die Konfigurationsparameter, wie beispielsweise Schutzparameter, einerseits im Schaltgerät und zusätzlich auch in einem internen Speicher des Schaltungsmoduls und/oder im Leitsystem gespeichert. Dadurch ist insbesondere beim Auswechseln eines Schaltgerätes eine automatische Parametrierung möglich.

Erkennt das Schaltungsmodul ein neues Schaltgerät an einer Kommunikationsschnittstelle, so überträgt es im internen Speicher gespeicherte Konfigurationsdaten zu dem neuen Schaltgerät.

Falls Konfigurationsdaten im Leitsystem gespeichert sind, fordert das Schaltungsmodul diese nach Detektion des neuen Schaltgerätes vom Leitsystem an und überträgt sie anschließend in das neue Schaltgerät.

Auf diese Art kann ein Schaltgerät gegen ein anderes ausgetauscht werden, ohne dass ein manueller Programmierschritt des Schaltgeräts nötig ist. Die Konfigurationsparameter werden dem Schaltgerät automatisch zugewiesen.

Eine Weiterbildung des Erfindungsgegenstandes sieht vor, das Schaltungsmodul zum Betrieb an unterschiedlichen Feldbussystemen anpassbar zu machen. Hierzu besitzt das Schaltungsmodul ein auswechselbares Schnittstellenmodul, auf dem die Feldbusschnittstelle und eine elektronische Schaltung, vorzugsweise auf einer Platine, angeordnet sind. Es stehen Schnittstellenmodule für verschiedene Übertragungsmedien, beispielsweise RS485, RS422, Ethernet, Lichtwellenleiter, sowie für mehrere Übertragungsprotokolle wie beispielsweise CAN-Bus, Profibus, Interbus, LON und MODBUS zur Verfügung.

Zudem wird die Aufgabe durch eine erfindungsgemäße Schaltungsanordnung gelöst, welche ein Schaltungsmodul aufweist, das zwischen einem Feldbus und einem Schaltgerät angeordnet ist. Dabei ist die Feldbusschnittstelle des Schaltungsmoduls mit dem Feldbus verbunden und die mindestens eine Kommunikationsschnittstelle ist über mindestens eine Datenleitung mit mindestens einem Schaltgerät verbunden.

In einer vorteilhaften Ausgestaltung weist die Datenleitung, welche das Schaltgerät mit dem Schaltungsmodul verbindet, eine Kupplung, insbesondere eine Steckverbindung auf. Somit kann das Schaltgerät vergleichsweise einfach von dem Schaltungsmodul getrennt und ausgewechselt werden.

Vorteilhaft ist weiterhin, das Schaltgerät in einen ausfahrbaren Einschub eines Schaltschranks und das Schaltungsmodul in einem feststehenden Teil des Schaltschranks anzuordnen. Die Datenleitung verläuft dabei im feststehenden Teil des Schaltschranks vom Schaltungsmodul zu einem Steuerstecker des Einschubfachs und weiter innerhalb des Einschubs vom Steuerstecker zum Schaltgerät. Somit kann das Schaltgerät durch Ausfahren des Einschubs von dem Schaltungsmodul getrennt und ausgewechselt werden.

Das Schaltungsmodul kann bei ausgefahrenem Einschub, wenn die Datenleitung vom Schaltungsmodul zum Schaltgerät über den Steuerstecker unterbrochen ist, weiter über den Feldbus mit anderen Busteilnehmem kommunizieren, Insbesondere kann es Anfragen, beispielsweise von einem Leitsystem, die an das Schaltgerät gerichtet sind, selbst beantworten.

Außerdem wird die Aufgabe durch eine erfindungsgemäße Schaltanlage gelöst, welche mindestens einen Schaltschrank, mindestens einen Feldbus und mindestens ein Schaltungsmodul aufweist.

Es erweist sich als vorteilhaft, die Feldbusadressen der Schaltungsmodule abhängig von deren örtlicher Anordnung in der Schaltanlage und/oder von der Anordnung der angeschlossenen Schaltgeräte, beziehungsweise der den Schaltgeräten zugeordneten Einschubfächern, festzulegen. Beispielsweise wird innerhalb der Schaltanlage jedem Schaltschrank ein Adressbereich zugewiesen und innerhalb jedes Schaltschranks jedem Schaltungsmodul eine Adresse aus diesem Adressbereich. Dadurch kann am Leitsystem anhand der Feldbusadresse jedes Schaltgerät der Schaltanlage lokalisiert werden. Die Feldbusadresse ist in der Regel innerhalb der Schaltanlage und des Feldbusses eindeutig und ist genau einem Einschubfach zugeordnet.

Die Festlegung der entsprechenden Feldbusadressen kann automatisch erfolgen, indem an den Plätzen, welche für die Aufnahme von Schaltungsmodulen vorgesehen sind, Kodiermittel angebracht sind, welche die vorgesehenen Feldbusadressen enthalten.

Verfügt das Schaltungsmodul über ein auswechselbares Schnittstellenmodul, so ergibt sich der Vorteil, dass die Verkabelung innerhalb des Schaltschranks weitgehend unabhängig vom verwendeten Feldbus ist. Die Datenleitungen, die von den Kommunikationsschnittstellen der Schaltungsmodule zu den Steuersteckern der Einschubfächer verlegt werden, sind immer gleich, ebenso die Datenleitung in einem Einschub vom Steuerstecker zum Schaltgerät. Lediglich die Verkabelung des Feldbusses zu den Feldbusschnittstellen der Schaltungsmodule ist entsprechend der Feldbusspezifikation auszuführen.

Anhand der Zeichnungen, in denen Ausführungsbeispiele der Erfindung dargestellt sind, werden die Erfindung, vorteilhafte Ausgestaltungen und Verbesserungen der Erfindung, sowie weitere Vorteile näher erläutert und beschrieben.

Es zeigen:
- Fig. 1: den Anschluss eines Schaltgeräts an ein Anschaltungsmodul,
- Fig. 2: eine regelmäßige Geräteanordnung und die Adressierung in einem Schaltschrank,
- Fig. 3: eine unregelmäßige Geräteanordnung mit verschiedenen Anschaltungsmodulen und
- Fig. 4: die Anbindung eines Leitsystems an eine Schaltanlage durch einen Feldbus.

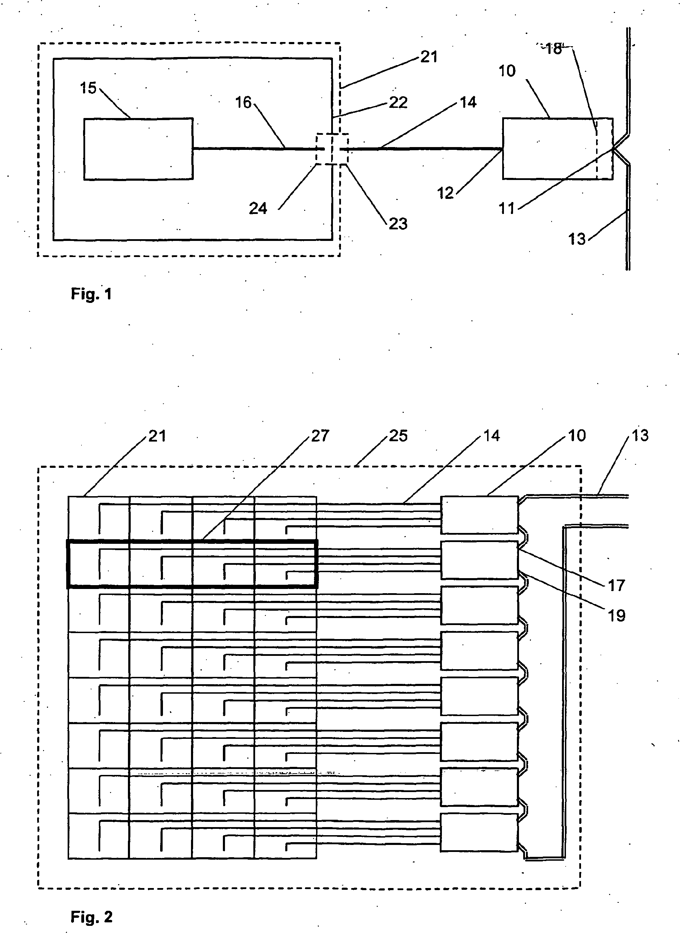

Fig. 1 zeigt schematisch, wie ein Schaltgerät 15 an ein Anschaltungsmodul 10, das auch als Schaltungsmodul bezeichnet wird, angeschlossen wird. Das Schaltgerät 15 befindet sich in einem Einschub 22, der in ein Einschubfach 21 eingefahren ist. Die elektrische Verbindung zwischen dem Einschub 22 und dem Einschubfach 21 geschieht über einen Steuerstecker 24 und eine Buchse 23, die in dieser Darstellung kontaktiert sind.

Das Schaltgerät 15 ist über eine erste Datenleitung 16 mit dem Steuerstecker 24 im Einschub 22 verbunden. Die Buchse 23 des Einschubfachs 21 ist über eine zweite Datenleitung 14 mit einer Kommunikationsschnittstelle 12 des Anschaltungsmoduls 10 verbunden.

Das Anschaltungsmodul 10 ist über eine Feldbusschnittstelle 11 mit einem Feldbus 13 verbunden, an den unter anderem auch ein Leitsystem angeschlossen ist. Die Feldbusschnittstelle 11 ist dabei auf einem auswechselbaren Schnittstellenmodul 18 angeordnet.

Aus Sicht des Leitsystems stellt die hier gezeigte Anordnung einen einzigen Busteilnehmer dar. Die Feldbusadresse dieses komplexen Busteilnehmers ist im Anschaltungsmodul 10 gespeichert.

Befehle, Abfragen oder sonstige Daten, die das Anschaltungsmodul 10 über die Feldbusschnittstelle 11 empfängt, leitet es über die Kommunikationsschnittstelle 12 zum Schaltgerät 15 weiter. Entsprechendes gilt für die entgegengesetzte Datenflussrichtung.

Wird der Einschub 22 aus dem Einschubfach 21 ausgefahren; so wird der Steuerstecker 24 von der Buchse 23 getrennt und damit die Datenleitungen 14 und 16 unterbrochen. Das Anschaltungsmodul 10 erkennt diese Unterbrechung und sendet eine entsprechende Diagnosemeldung an das Leitsystem. Aus Sicht des Leitsystems ist der Busteilnehmer aber immer noch vorhanden, die Kommunikation auf dem Feldbus 13 bleibt also unbeeinflusst.

Fig. 2 zeigt eine Möglichkeit zur Anordnung und Adressierung der Geräte in einem Schaltschrank 25. Der Schaltschrank 25 verfügt in diesem Fall über 32 Einschubfächer 21, die in acht Einschubetagen 27 angeordnet sind. Die Einschübe, Schaltgeräte, Steuerstecker und Buchsen sind hier nicht dargestellt, ihre Anordnung ist Fig. 1 zu entnehmen.

Im Schaltschrank 25 befinden sich acht Anschaltungsmodule 10, also jeweils eins pro Einschubetage 27. Jedes Anschaltungsmodul 10 weist vier Kommunikationsschnittstellen auf, die über jeweils eine Datenleitung 14 mit je einer Buchse eines Einschubfachs 21 verbunden sind. Der Feldbus 13, an den die Anschaltungsmodule 10 angeschlossen sind, ist weitergeführt zu anderen Schaltschränken der Schaltanlage und zu einem Leitsystem.

Der Feldbus 13 ist im hier dargestellten Fall als Ringleitung ausgeführt. Es kommen daher Anschaltungsmodule 10 zum Einsatz, deren Feldbusschnittstelle über zwei Anschlüsse 17, 19 verfügt.

Ist dem Schaltschrank 25 beispielsweise der Adressbereich von "32" bis "63" zugeordnet, so erhält das in der Zeichnung oben angeordnete Anschaltungsmodul 10 die Adresse "32" und damit auch die Adressen "33", "34" und "35". Jede dieser 4 Feldbusadressen wird je einer der 4 Kommunikationsschnittstellen und damit einem Einschubfach zugeordnet. Aus Sicht des Leitsystems besitzt also jedes Einschubfach eine eindeutige und feste Feldbusadresse.

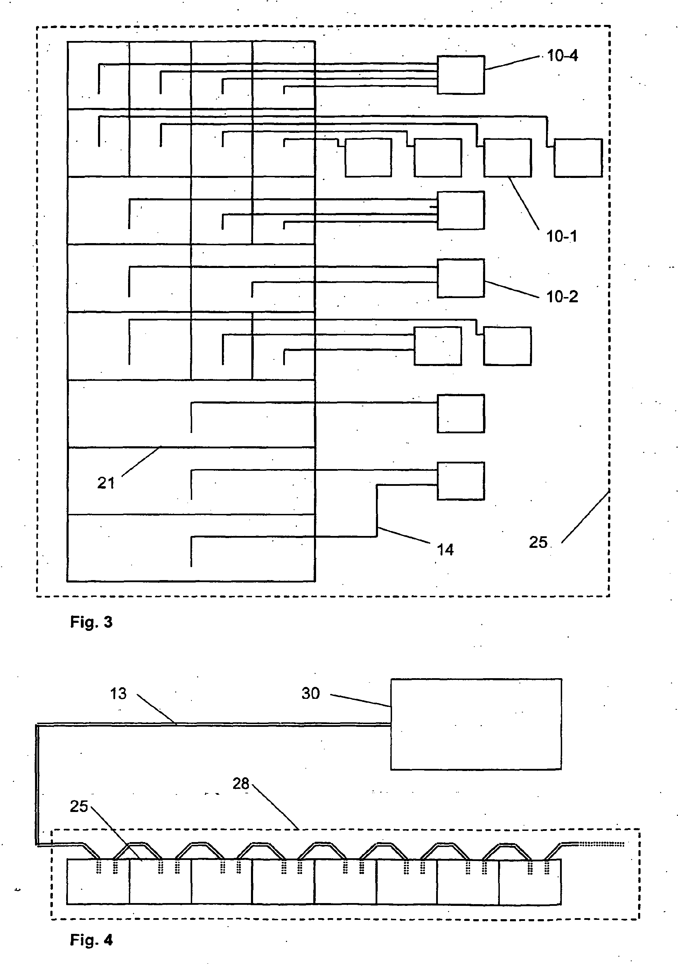

Fig. 3 zeigt ein Beispiel für eine unregelmäßige Anordnung von Geräten in einem Schaltschrank 25. In den einzelnen Einschubetagen sind unterschiedlich viele Einschubfächer 21 verschiedener Größe vorhanden. Der Feldbus und die Feldbusschnittstellen der Anschaltungsmodule sind hier nicht dargestellt.

In diesem Beispiel werden Anschaltungsmodule 10-4 eingesetzt, die über je vier Kommunikationsschnittstellen verfügen, sowie Anschaltungsmodule 10-2 mit je zwei und Anschaltungsmodule 10-1 mit je einer Kommunikationsschnittstelle. Aber auch Anschaltungsmodule mit einer anderen Anzahl von Kommunikationsschnittstellen sind denkbar.

Es ergeben sich mehrere Möglichkeiten, die Einschubfächer 21 einer Einschubetage und damit die darin enthaltenen Schaltgeräte an den Feldbus anzuschalten.

So können beispielsweise alle Einschubfächer 21 einer Einschubetage mit einem gemeinsamen Anschaltungsmodul 10-4 oder 10-2 angeschaltet werden, ebenso ist es möglich, für jedes Einschubfach 21 ein separates Anschaltungsmodul 10-1 vorzusehen. Besitzt das verwendete Anschaltungsmodul 10-2 oder 10-4 mehr Kommunikationsschnittstellen als Einschubfächer 21 anzuschalten sind, so können Kommunikationsschnittstellen und damit auch zugeordnete Feldbusadressen ungenutzt bleiben. Es ist auch denkbar, verschiedenartige Anschaltungsmodule 10-1 und 10-2 innerhalb einer Einschubetage zu kombinieren.

Weiterhin können mit einem Anschaltungsmodul 10-2 oder 10-4 Einschubfächer 21 in verschiedenen Einschubetagen angeschaltet werden.

Fig. 4 zeigt die Anbindung eines Leitsystems 30 über den Feldbus 13 an eine Schaltanlage 28. Die Schaltanlage besteht aus mehreren Schaltschränken 25. Der Feldbus 13 ist als Ringleitung ausgeführt und verbindet mehrere Schaltschränke 25 miteinander und mit dem Leitsystem 30.

Die Ringleitung kann sowohl als geschlossener Ring ausgeführt sein, das heißt, vom letzten Schaltschrank wird die Leitung zurück zum Leitsystem 30 geführt, als auch als offener Ring, das heißt, die Leitung endet am letzten Teilnehmer im letzten Schaltschrank und wird eventuell mit einem Abschlusswiderstand abgeschlossen.

## Patentansprüche

1. Schaltungsmodul (10) zur Anschaltung von wenigstens einem in einem Einschub (22) eines Schaltschranks (25) einer Schaltanlage (28) befindlichen Schaltgerät (15) an einen in der Schaltanlage (28) vorhandenen Feldbus (13), **dadurch gekennzeichnet, dass** das Schaltungsmodul (10) über eine Feldbusschnittstelle (11) mit dem Feldbus (13) und über wenigstens eine Kommunikationsschnittstelle (12) mittels wenigstens einer Steckverbindung (23, 24) mit dem wenigstens einem Schaltgerät (15) des Schaltschranks (25) verbunden ist, das Schaltungsmodul (10) eine innerhalb des Feldbusses (13) eindeutige Feldbusadresse aufweist und das Schaltungsmodul (10) dafür eingerichtet ist, auch dann über den Feldbus (13) zu kommunizieren, wenn das wenigstens eine Schaltgerät (15) von der Kommunikationsschnittstelle (12) getrennt ist.

2. Schaltungsmodul (10) nach Anspruch 1, **dadurch gekennzeichnet, dass** die Feldbusadresse des Schaltungsmoduls (10) durch dessen örtliche Anordnung in der Schaltanlage (28) und/oder durch die örtliche Anordnung der angeschlossenen Schaltgeräte (15) in der Schaltanlage (28) bestimmt ist.

3. Schaltungsmodul (10) nach Anspruch 2, **dadurch gekennzeichnet, dass** das Schaltungsmodul (10) ein Dekodiermittel zur Einstellung der Feldbusadresse aufweist und die Feldbusadresse in einem Kodiermittel enthalten ist, welches von dem Dekodiermittel interpretierbar ist.

4. Schaltungsmodul (10) nach einem der vorstehenden Ansprüche, **dadurch gekennzeichnet, dass** die Feldbusschnittstelle (11) zu einem bidirektionalen Datenaustausch über den Feldbus (13) mit einem Leitsystem (30) und/oder mit weiteren Schaltungsmodul (10) und/oder mit sonstigen Feldbusteilnehmern eingerichtet ist.

5. Schaltungsmodul (10) nach einem der vorstehenden Ansprüche, **dadurch gekennzeichnet, dass** die wenigstens eine Kommunikationsschnittstelle (12) zu einem bidirektionalen Datenaustausch mit dem wenigstens einen Schaltgerät (15) eingerichtet ist.

6. Schaltungsmodul (10) nach einem der vorstehenden Ansprüche, **dadurch gekennzeichnet, dass** eine Überwachung der angeschlossenen Schaltgeräte (15) durchführbar ist.

7. Schaltungsmodul (10) nach einem der vorstehenden Ansprüche, **dadurch gekennzeichnet, dass** eine Speicherung von Konfigurationsparametern des wenigstens einen an die wenigstens eine Kommunikationsschnittstelle (12) angeschlossenen Schaltgerätes (15) durchführbar ist.

8. Schaltungsmodul (10) nach einem der vorstehenden Ansprüche, **dadurch gekennzeichnet, dass** eine Übertragung von gespeicherten Konfigurationsparametern an das wenigstens eine an die wenigstens eine Kommunikationsschnittstelle (12) angeschlossene Schaltgerät (15) durchführbar ist.

9. Schaltungsmodul (10) nach einem der vorstehenden Ansprüche, **dadurch gekennzeichnet, dass** ein Einlesen von Konfigurationsparametern über die Feldbusschnittstelle (11) und eine Übertragung der eingelesenen Konfigurationsparameter an das wenigstens eine an die wenigstens eine Kommunikationsschnittstelle (12) angeschlossene Schaltgerät (15) durchführbar ist.

10. Schaltungsmodul (10) nach einem der vorstehenden Ansprüche, **dadurch gekennzeichnet, dass** die Feldbusschnittstelle (11) auf einem auswechselbaren Schnittstellenmodul (18) angeordnet ist.

11. Schaltungsanordnung zur Anschaltung wenigstens eines Schaltgeräts (15) an einen Feldbus (13), **dadurch gekennzeichnet, dass** ein Schaltungsmodul (10) nach einem der Ansprüche 1 bis 10 dem wenigstens einen Schaltgerät (15) und dem Feldbus (13) zwischengeschaltet ist.

12. Schaltungsanordnung nach Anspruch 11, **dadurch gekennzeichnet, dass** das Schaltungsmodul (10) mittels wenigstens einer Kupplung, insbesondere einer Steckverbindung (23, 24), mit dem wenigstens einen Schaltgerät (15) verbunden ist.

13. Schaltungsanordnung nach einem der Ansprüche 11 oder 12, **dadurch gekennzeichnet, dass** das wenigstens eine Schaltgerät (15) in einem Einschub (22) eines Schaltschranks (25) angeordnet ist, und dass das Schaltungsmodul (10) in einem feststehenden Teil des Schaltschranks (25) angeordnet ist.

14. Schaltanlage (28), insbesondere in Einschubtechnik, mit mindestens einem Schaltschrank (25) und mindestens einem Feldbus (13), in welcher mindestens ein Schaltungsmodul (10) gemäß einem der Ansprüche 1 bis 12 angeordnet ist.

## Claims

1. A circuit module (10) for connection of at least one switching device (15) to a field bus present in the switchgear (28), which switching device is disposed in a slide-in unit (22) of a switch cabinet (25) of a switchgear (28), **characterized in that** the circuit module (10) is connected with the at least one switching device (15) of the switch cabinet (25) via a field bus interface (11) with the field bus (15) and via at least one communication interface (12) by means of at least one plug-in connection (23, 24), the circuit module (10) has a field bus address which is unique within the field bus (13) and the circuit module (10) is set up to communicate via the field bus (13) even when the at least one switching device (15) is separated from the communication interface (12).

2. A circuit module (10) according to claim 1, **characterized in that** the field bus address of the circuit module (10) is determined by its local arrangement in the switchgear (28) and/or by the local arrangement of the connected switching devices (15) in the switchgear (28).

3. A circuit module (10) according to claim 2, **characterized in that** the circuit module (10) comprises a decoding means for setting the field bus address and the field bus address is contained in an encoding means which can be interpreted by the decoding means.

4. A circuit module (10) according to one of the preceding claims, **characterized in that** the field bus interface (11) is arranged for bidirectional exchange of data via the field bus (13) with a control system (30) and/or a further circuit module (10) and/or other field bus subscribers.

5. A circuit module (10) according to one of the preceding claims, **characterized in that** the at least one communication interface (12) is arranged for bidirectional exchange of data with the at least one switching device (15).

6. A circuit module (10) according to one of the preceding claims, **characterized in that** monitoring of the connected switching devices (15) can be performed.

7. A circuit module (10) according to one of the preceding claims, **characterized in that** a storage of configuration parameters of the at least one switching device (15) which is connected to the at least one communication interface (12) can be performed.

8. A circuit module (10) according to one of the preceding claims, **characterized in that** a transmission of stored configuration parameters to the at least one switching device (15) which is connected to the at least one communication interface (12) can be performed.

9. A circuit module (10) according to one of the preceding claims, **characterized in that** the reading in of configuration parameters via the field bus interface (11) and a transmission of the read configuration parameters to the at least one switching device (15) which is connected to the at least one communication interface (12) can be performed.

10. A circuit module (10) according to one of the preceding claims, **characterized in that** the field bus interface (11) is arranged on an exchangeable interface module (18).

11. A circuit arrangement for connection of at least one interface device (15) to a field bus (13), **characterized in that** a circuit module (10) according to one of the claims 1 to 10 is interposed between the at least one switching device (15) and the field bus (13).

12. A circuit arrangement according to claim 11, **characterized in that** the circuit module (10) is connected by means of at least one coupling, especially a plug-in connection (23, 24), with the at least one switching device (15).

13. A circuit arrangement according to one of the claims 11 or 12, **characterized in that** the at least one switching device (15) is arranged in a slide-in unit (22) of a switch cabinet (25) and the circuit module (10) is arranged in a fixed part of the switch cabinet (25).

14. A switchgear (28), especially in plug-in technology, comprising at least one switch cabinet (25) and at least one field bus (13) in which at least one circuit module (10) according to one of the claims 1 to 12 is arranged.

## Revendications

1. Module de connexion (10) pour la connexion d'au moins un appareil de commutation (15) situé dans un tiroir (22) d'une armoire électrique (25) d'une installation de commutation (28) à un bus de terrain (13) présent dans l'installation de commutation (28), **caractérisé en ce que** le module de connexion (10) est connecté par une interface de bus de terrain (11) au bus de terrain (13) et par au moins une interface de communication (12), au moyen d'au moins une connexion enfichée (23, 24), à l'au moins un appareil de commutation (15) de l'armoire électrique (25), le module de connexion (10) présente une adresse de bus de terrain sans équivoque à l'intérieur du bus de terrain (13) et le module de connexion (10) est équipé pour communiquer par le bus de terrain (13) même quand l'au moins un appareil de commutation (15) est coupé de l'interface de communication (12).

2. Module de connexion (10) selon la revendication 1, **caractérisé en ce que** l'adresse de bus de terrain du module de connexion (10) est déterminée par sa disposition locale dans l'installation de commutation (28) et/ou par la disposition locale des appareils de commutation (15) dans l'installation de commutation (28).

3. Module de connexion (10) selon la revendication 2, **caractérisé en ce que** le module de connexion (10) comprend un moyen de décodage pour le réglage de l'adresse de bus de terrain et l'adresse de bus de terrain est contenue dans un moyen de codage qui peut être interprété par le moyen de décodage.

4. Module de connexion (10) selon l'une des revendications précédentes, **caractérisé en ce que** l'interface de bus de terrain (11) est équipée en vue d'un échange de données bidirectionnel sur le bus de terrain (13) avec un système de commande (30) et/ou avec d'autres modules de connexion (10) et/ou avec d'autres appareils connectés au bus de terrain.

5. Module de connexion (10) selon l'une des revendications précédentes, **caractérisé en ce que** l'au moins une interface de communication (12) est équipée en vue d'un échange de données bidirectionnel avec l'au moins un appareil de commutation (15).

6. Module de connexion (10) selon l'une des revendications précédentes, **caractérisé en ce qu'**une surveillance des appareils de commutation (15) connectés est possible.

7. Module de connexion (10) selon l'une des revendications précédentes, **caractérisé en ce qu'**un enregistrement de paramètres de communication de l'au moins un appareil de commutation (15) raccordé à l'au moins une interface de communication (12) est possible.

8. Module de connexion (10) selon l'une des revendications précédentes, **caractérisé en ce qu'**une transmission de paramètres de configuration enregistrés à l'au moins un appareil de commutation (15) raccordé à l'au moins une interface de communication (12) est possible.

9. Module de connexion (10) selon l'une des revendications précédentes, **caractérisé en ce qu'**une lecture de paramètres de configuration sur l'interface de bus de terrain (11) et une transmission des paramètres de configuration lus à l'au moins un appareil de commutation (15) raccordé à l'au moins une interface de communication (12) sont possibles.

10. Module de connexion (10) selon l'une des revendications précédentes, **caractérisé en ce que** l'interface de bus de terrain (11) est disposée sur un module d'interface (18) interchangeable.

11. Disposition de connexion pour la connexion d'au moins un appareil de commutation (15) à un bus de terrain (13), **caractérisée en ce qu'**un module de connexion (10) selon l'une des revendications 1 à 10 est connecté entre l'au moins un appareil de commutation (15) et le bus de terrain (13).

12. Disposition de connexion selon la revendication 11, **caractérisée en ce que** le module de connexion (10) est relié au moyen d'au moins un couplage, en particulier d'une connexion enfichée (23, 24), à l'au moins un appareil de commutation (15).

13. Disposition de connexion selon l'une des revendications 11 ou 12, **caractérisé en ce que** l'au moins un appareil de commutation (15) est disposé dans un tiroir (22) d'une armoire électrique (25) et **en ce que** le module de connexion (10) est disposé dans une partie fixe de l'armoire électrique (25).

14. Installation de commutation (28), en particulier équipée de tiroirs, avec au moins une armoire électrique (25) et au moins un bus de terrain (13), dans laquelle au moins un module de connexion (10) selon l'une des revendications 1 à 12 est disposé.
